# EUROPEAN PATENT APPLICATION

(11) **EP 1 130 879 A1**
(43) Date of publication of application: **05.09.2001**
(21) Application number: 01400417.0
(22) Date of filing: 16.02.2001
(51) Int. Cl.: H04M 1/02, H05K 5/00

(54) **Casing for electronic equipment**

(30) Priority: 02.03.2000 FR 0002711
(71) Applicant: Mitsubishi Electric Telecom Europe, 92000 Nanterre (FR)
(72) Inventor: Michel, Stéphane, 35160 Montfort sur Meu (FR); Naslain, Yann, 35000 Rennes (FR); Roussy, Pascal, 35830 Betton (FR); Le Foulgoc, Jean-Marc, 35220 Chateaubourg (FR); Rouxel, Mickael, 35700 Rennes (FR)
(74) Representative: Blot, Philippe Robert Emile

(57) **Abstract**

The casing (10) for electronic equipment comprises first and second structural elements (12, 14) and means for mechanically connecting the first and second structural elements (12, 14) by elastic engagement. Said means of mechanical connection comprise:
- an elastically deformable leg (22) integral with said first structural element;
- a transverse projection (24) borne by said leg (22); and
- a shoulder (34) formed on said second structural element (14), said shoulder (34) constituting a stop designed to collaborate with said projection (24) and hold said leg (22) in place.

According to the invention, said means of mechanical connection by elastic engagement comprise removable means (50) of immobilizing said projection (24) facing said shoulder (34).

Application to mobile telephones.

## Description

The present invention relates to a casing for electronic equipment comprising a first structural element, a second structural element and means for mechanically connecting the first and second structural elements by elastic engagement, said means for mechanical connection by elastic engagement comprising:
- an elastically deformable leg integral with said first structural element;
- a projection borne by one of these elements - either said leg or said second structural element - said projection extending transversely to said leg when said first and second structural elements are connected; and
- a shoulder formed on the other element - either said leg or said second structural element - said shoulder extending transversely to said leg when said first and second structural elements are connected, said projection being arranged facing said shoulder when said first and second structural elements are connected, said shoulder then constituting a stop designed to collaborate with said projection and hold said leg in place.

Nowadays, electronic equipment, particularly mobile telecommunications equipment such as mobile telephones, comprises a casing made of plastic, inside which the electronic circuits which allow operation are housed.

The casings generally comprise at least two structural elements assembled around the internal electronic circuits.

In order to reduce the time taken to assemble the casings and the cost price of the mobile telephones, there is a tendency to avoid the use of assembly screws. Assembly is therefore achieved using complementary projecting and recessed profiles borne by the structural elements, these complementary profiles providing a mechanical connection by the elements being elastically engaged together. The connection is thus achieved by clipping together.

It has been found that the connecting of structural elements by elastic engagement does not give a reliable assembly. This is because, for ease of assembly and to allow easy manual disassembly, the elastically deformable elements which provide the elastic engagement need to be relatively flexible. Thus, the structural elements may easily become accidentally detached, particularly if the equipment is dropped.

To improve the strength of the assembly, the rigidity of the elastic means may be increased. However, it is then no longer possible for the structural elements of the mobile telephone to be disassembled manually.

The object of the invention is to provide a solution to this problem of the reliability of the assembly of the structural elements of the casing of electronic equipment, which allows easy, quick and therefore economical assembly of the structural elements and which in addition is compatible with easy manual disassembly thereof.

To this end, the subject of the invention is a casing for electronic equipment of the aforementioned type, characterized in that said means for mechanical connection by elastic engagement comprise removable means for immobilizing said projection facing said shoulder.

According to some particular embodiments, the casing has one or more of the following features:
- said removable immobilizing means of said projection facing said shoulder comprise a stop for immobilizing said leg, said immobilizing stop being designed to lie along said leg on the opposite side of said leg to said projection when said first and second structural elements are connected;
- said second structural element has a slot for the passage of said leg, and said stop for immobilizing said leg comprises a tongue designed to be accommodated in said passage slot along said leg;
- said tongue has transverse dimensions designed to approximately fill the entire gap separating said leg from the edge of said passage slot on the opposite side of said leg to said projection;
- said projection is borne by said leg and said shoulder is formed within said second structural element; and
- it comprises a third structural element and said removable means for immobilizing said projection facing said shoulder are made as one piece with said third structural element.

A further subject of the invention is mobile telecommunication equipment comprising a casing as defined hereinabove.

In an alternative form:
- the equipment further comprises a removable battery and a movable cover for covering said battery , and said removable means for immobilizing said projection facing said shoulder are integral with said movable cover for covering said battery ; and
- the equipment further comprises a removable battery , and said removable means for immobilizing said projection facing said shoulder are integral with said battery .

In particular, the mobile telecommunications equipment is a portable telephone.

The invention will be better understood from reading the description which will follow, which is given merely by way of example with reference to the drawings, in which:
- Figure 1 is a view in exploded perspective of the casing of a mobile telephone according to the invention; and
- Figure 2 is a part view in cross section of the casing of Figure 1, taken on a plane transverse to the means of mechanical connection by elastic engagement which provides the mechanical connection between at least two structural elements of the casing; and
- Figure 3 is a perspective view of a battery designed to be fitted into an alternative form of a mobile telephone casing according the invention.

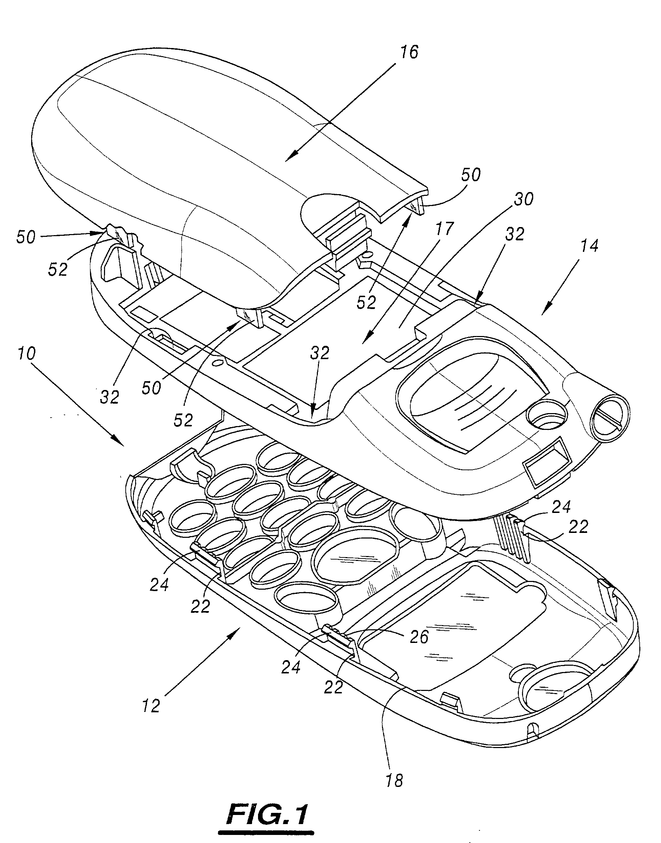

The casing 10 depicted in Figure 1 is a mobile telephone casing.

It comprises a front half-shell 12, a rear half-shell 14 and a battery- cover 16. The front half-shell 12 is designed to take a keypad and a display screen. The rear half-shell 14 externally defines a housing 17 for accommodating a battery , the cover 16 being designed to close this housing and hold the power battery therein.

The half-shells 12 and 14 are connected together in a joining mid-plane 18 running along the length of the casing.

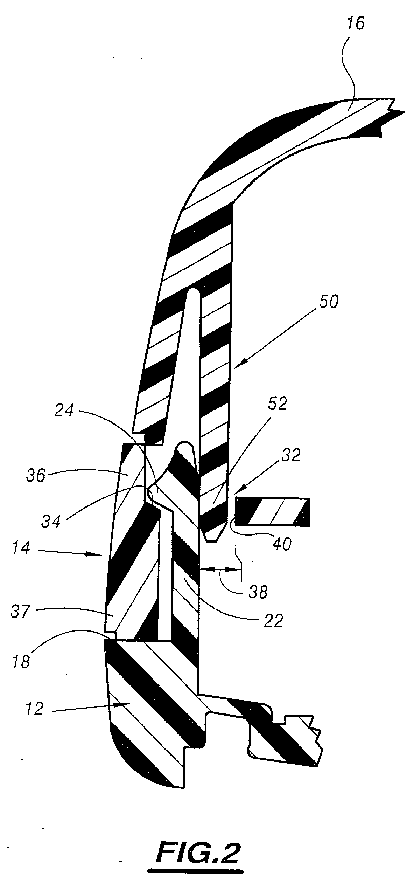

The half-shells 12 and 14 are held together by means of mechanical connection by elastic engagement. These means are formed in four regions spread around the periphery of the joining plane 18 of the half-shells. They are depicted in Figure 2 in a position in which they connect the half-shells 12 and 14. The various constituent parts of the connecting means are shown in Figure 1, in which they are separated.

In the embodiment described in Figures 1 and 2, these connecting means comprise an elastically deformable leg 22 integral with the front half-shell 12. The leg 22 is formed as an integral part of the front half-shell 12. It extends generally at right angles to the joining plane 18.

At its free end, the leg 22 has a projection 24 which projects from the overall plane of the leg 22, this projection facing towards the outside of the casing.

On its opposite face to the face bearing the projection 24, the leg 22 has longitudinal stiffening ribs 26.

The projection 24 extends across the entire width of the leg 22, more or less parallel to the joining plane 18.

The housing 17 intended to take the battery has a bottom 30 able to form a bearing surface for the battery . Slots 32 are formed in the bottom 30 facing the legs 22. These slots 32 are designed for the passage of the legs.

Each slot 32 is bordered on one side by a shoulder 34. This shoulder is formed on the exterior surface of the bottom 30 on the opposite side to the front half-shell 12 when the two half-shells are assembled. It extends along that side of the slot towards which the projection 24 faces when the half-shells are assembled, that is to say towards the outside of the casing.

As illustrated in Figure 2, the shoulder 34 is defined between the slot 32 for the passage of the leg 22 and an extension 36 of a side wall 37 of the rear half-shell 14.

Moreover, the width of the slot 32 in the plane of Figure 2 is greater than the thickness of the leg 22 in its main portion, so as to allow for the passage of the projection 24, the latter locally increasing the thickness of the leg 22.

The leg 22, with its projection 24, is designed to collaborate with the shoulder 34 and thus provide a mechanical connection by elastic engagement of the half-shells 12 and 14.

For this purpose, and as illustrated in Figure 2, when the half-shells 12, 14 are assembled, the end of the leg 22 passes through the bottom 30 through the slot 32. The projection 24 is then housed beyond the exterior surface of the bottom 30 and extends facing the shoulder 34. The shoulder 34 therefore constitutes a stop designed to collaborate with the projection 24 and thus hold the leg 22 in place.

In this position, there is a gap 38 defined between the opposite surface of the leg 22 to the projection 24 and the edge facing it, denoted 40, of the slot 32.

According to the invention, the means of mechanical connection by elastic engagement comprise removable means 50 for immobilizing the projection 24 facing the shoulder 34. Thus, all the structural elements of the casing are held locked in their assembly position and therefore remain fully secured together. In this way, any accident befalling the portable telephone, such as its being dropped, for example, will not cause its structural elements to become unintentionally disassembled.

These removable immobilizing means comprise a stop for immobilizing the leg 22. This stop is formed by a tongue 52 designed to run along the leg 22 on the opposite side to the projection 34 when the leg is passed through the slot 32. The tongue 52 therefore extends into the gap 38.

The thickness of the tongue 52 is advantageously more or less equal to or very slightly less than the width of the gap 38.

In the embodiment depicted in Figures 1 and 2, the tongue 52 is formed as an integral part of the battery cover 16. Thus, no additional parts attached within the portable telephone for, in particular, on the one hand, holding the front 12 and rear 14 half-shells in their assembled position and, on the other hand, allowing easy deliberate disassembly of these half-shells 12, 14 need be provided. Thus, because the tongue 52 is integrated into an existing structural element of the casing of the mobile telephone (in this particular instance the battery cover 16), implementing this first embodiment, and implementing the second embodiment described later on, represent a negligible cost.

When the mobile telephone is in a use configuration, the front 12 and rear 14 half-shells are connected together by the elastic engagement of the legs 22 in the slots 32, and the cover 16 is held on the rear half-shell 14. Each tongue 52 is then inserted between the opposite surface of the leg 22 to the associated projection 24 and the edge 40 of the corresponding slot 32. The tongue immobilizes the projection 24 facing the associated shoulder 34.

Specifically, when tension with a view to releasing the projection 24 is exerted on a leg 22, the leg 22 presses on the tongue 52, which opposes the elastic deformation of the leg 22. If the pulling force is very intense, the leg 22 and the tongue 52 deform slightly under the action of the projection 24 collaborating with the shoulder 34 which acts as a cam. This deformation continues until the tongue 52 comes to rest against the edge 40 of the slot. In this position, the leg 22 is locked in place by the tongue 52 resting against the edge 40, so that this tongue can no longer elastically deform. The projection 24 is thus mechanically held facing the shoulder 34 without the projection 24 being able to escape.

It will thus be appreciated that the assembly of the half-shells 12 and 14 is made more reliable, as long as the cover 16 is held in place.

To disassemble the mobile telephone, removing the cover 16 allows the tongues 52 to be withdrawn from the slots 32. It is then possible for a user of the mobile telephone, by accessing them from the battery housing 17, to pull on the free end of each of the legs 22 using his finger and elastically deform them towards the inside of the mobile telephone, transversely to each projection 24. Thus, the user can easily disengage each projection 24 from the associated shoulder 34 in order to allow the front 12 and rear 14 half-shells to come apart and therefore be disassembled. It is to be noted that no additional special-purpose tools are required for doing this.

It will thus be appreciated that the means for immobilizing the projections give the connection of the half-shells great reliability when the telephone is in a use configuration. However, once the battery cover 16 has been removed, it is easy to disassemble the mobile telephone with a view to possible intervention on the elements located between the two half-shells.

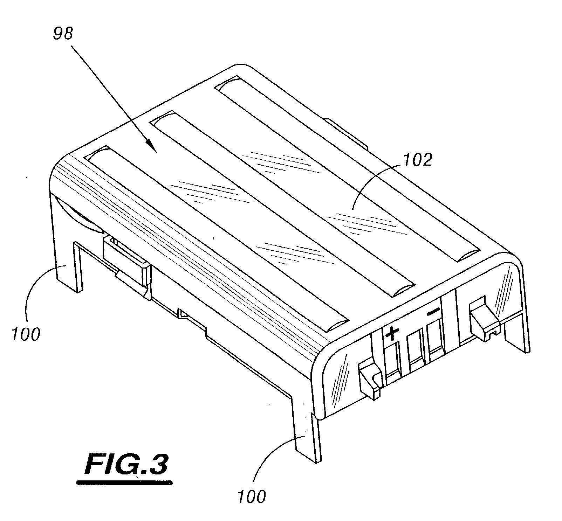

Figure 3 depicts a battery 98 which can be used in an alternative form of a mobile telephone comprising a casing according to the invention.

This alternative form differs from the one described with reference to Figures 1 and 2 only in that the cover 16 has no tongues 52 for immobilizing the projections borne by the legs facing the associated shoulders.

By contrast, in this embodiment, and as illustrated in Figure 3, tongues 100 are formed as an integral part of a body 102 of the battery , inside which the electric energy accumulators are housed. These tongues 100 are designed to be housed in the slots 32 in the rear half-shell 14. Just like the tongues 52, the tongues 100 are inserted between the legs 22 and the edge of the slots facing them.

In the embodiments depicted in Figures 2 and 3, the projections of the mechanical connecting means are borne by the elastic legs whereas the shoulders collaborating with the projections are formed on the other structural element of the casing.

As an alternative, the shoulders are formed on the elastic legs and the projections are borne by the complementary structural element of the casing.

Likewise, according to another embodiment of the invention, the legs are integral with the rear half-shell 14 and the shoulders are then formed in the front half-shell 12.

## Claims

1. Casing (10) for electronic equipment comprising a first structural element (12), a second structural element (14) and means for mechanically connecting the first and second structural elements (12, 14) by elastic engagement, said means for mechanical connection by elastic engagement comprising:
- an elastically deformable leg (22) integral with said first structural element (12);
- a projection (24) borne by one of these elements - either said leg (22) or said second structural element (14)- said projection (24) extending transversely to said leg (22) when said first and second structural elements (12, 14) are connected; and
- a shoulder (34) formed on the other element - either said leg (22) or said second structural element (14)- said shoulder (34) extending transversely to said leg (22) when said first and second structural elements (12, 14) are connected, said projection (24) being arranged facing said shoulder (34) when said first and second structural elements (12, 14) are connected, said shoulder (34) then constituting a stop designed to collaborate with said projection (24) and hold said leg (22) in place;
**characterized in that** said means for mechanical connection by elastic engagement comprise removable means (50) for immobilizing said projection (24) facing said shoulder (34), said removable immobilizing means (50) comprising a stop (52) for immobilizing said leg (22), said immobilizing stop (52) being designed to lie along said leg (22) on the opposite side of said leg (22) to said projection (24) when said first and second structural elements (12, 14) are connected, in that said second structural element (14) has a slot (32) for the passage of said leg (22), and in that said stop for immobilizing said leg (22) comprises a tongue (52) designed to be accommodated in said passage slot (32) along said leg (22), between said leg (22) and an edge (40) of said passage slot (32).

2. Casing according to Claim 1, **characterized in that** said tongue (52) has transverse dimensions designed to approximately fill the entire gap (38) separating said leg (22) from the edge of said passage slot (32) on the opposite side of said leg (22) to said projection (24).

3. Casing according to any of the preceding claims, **characterized in that** said projection (24) is borne by said leg (22) and said shoulder (34) is formed within said second structural element (14).

4. Casing according to any of the preceding claims, **characterized in that** it further comprises a third structural element (16), and in that said removable means (52) for immobilizing said projection (24) facing said shoulder (34) are made as one piece with said third structural element (16).

5. Mobile telecommunication equipment comprising a casing (10) according to any of the preceding claims.

6. Mobile telecommunication equipment according to Claim 5, **characterized in that** it further comprises a removable battery and a movable cover (16) for covering said battery, and in that said removable means (52) for immobilizing said projection (24) facing said shoulder (34) are integral with said movable cover (16) for covering said battery.

7. Mobile telecommunication equipment according to Claim 5, **characterized in that** it further comprises a removable battery (98), and in that said removable immobilizing means (100) are integral with said battery (98).

8. Mobile telecommunication equipment according to any of Claims 5 to 7, **characterized in that** it is a portable telephone.
